# EUROPEAN PATENT APPLICATION

(11) **EP 4 783 808 A1**
(43) Date of publication of application: **29.07.2026**
(21) Application number: 25878436.2
(22) Date of filing: 30.07.2025
(51) Int. Cl.: H10N 30/60, H10N 30/30, H10N 30/857

(54) **PIEZOELECTRIC SENSOR WIRE**

(30) Priority: 28.11.2024 JP 2024207615
(71) Applicant: SUMITOMO ELECTRIC INDUSTRIES, LTD., Osaka-shi, Osaka 541-0041 (JP)
(72) Inventor: SUGIMURA, Kazuaki, Osaka-shi, Osaka 541-0041 (JP); MIYABE, Tadaaki, Osaka-shi, Osaka 541-0041 (JP); YAMASAKI, Kazuho, Osaka-shi, Osaka 541-0041 (JP); IWAMOTO, Katsutoshi, Osaka-shi, Osaka 541-0041 (JP); KAWABE, Nozomu, Osaka-shi, Osaka 541-0041 (JP)
(74) Representative: Grünecker Patent- und Rechtsanwälte PartG mbB
(86) International application number: PCT/JP2025/027072
(87) International publication number: WO 2026/115800

(57) **Abstract**

A piezoelectric sensor wire includes a core wire, an organic piezoelectric layer, and an electrode region. The core wire includes: a steel wire; and a covering layer made of copper or a copper alloy covering the steel wire. The core wire has a wire diameter of 30 µm or more and 200 µm or less. The organic piezoelectric layer covers an outer peripheral surface of the core wire so as to be in contact with the outer peripheral surface. The organic piezoelectric layer has an average thickness of 2.5 µm or more and 7.5 µm or less. The electrode region is in contact with the organic piezoelectric layer and surrounds the core wire while being spaced apart from the core wire. A wire diameter of the piezoelectric sensor wire is 300 µm or less. The covering layer is in contact with a first outer peripheral surface being an outer peripheral surface of the steel wire over an entire area of the first outer peripheral surface.

## Description

### Technical Field

The present disclosure relates to a piezoelectric sensor wire. This application claims priority from Japanese Patent Application No. 2024-207615, filed on November 28, 2024, the contents of which are incorporated herein by reference in their entirety.

### Background Art

There has been known a piezoelectric sensor wire including: a core wire; an organic piezoelectric layer that covers the core wire; and a conductor layer that covers the organic piezoelectric layer (see, for example, Patent Literature 1 below). The core wire of the piezoelectric sensor wire described in Patent Literature 1 includes a resin wire and a metal foil helically wound around the resin wire. In Patent Literature 1, there is described that a thickness of the organic piezoelectric layer is 40 µm. In each of Patent Literature 2 and Patent Literature 3, there is described that a thickness of the organic piezoelectric layer is 50 µm.

### Citation List

### Patent Literature

[PTL 1] JP 2020-043138 A
[PTL 2] JP 2021-170022 A
[PTL 3] JP 2019-67969 A

### Summary of Invention

According to the present disclosure, there is provided a piezoelectric sensor wire, including a core wire, an organic piezoelectric layer, and an electrode region. The core wire includes: a steel wire; and a covering layer made of copper or a copper alloy covering the steel wire. The core wire has a wire diameter of 30 µm or more and 200 µm or less. The organic piezoelectric layer covers an outer peripheral surface of the core wire so as to be in contact with the outer peripheral surface. The organic piezoelectric layer has an average thickness of 2.5 µm or more and 7.5 µm or less. The electrode region is in contact with the organic piezoelectric layer and surrounds the core wire while being spaced apart from the core wire. A wire diameter of the piezoelectric sensor wire is 300 µm or less. The covering layer is in contact with a first outer peripheral surface being an outer peripheral surface of the steel wire over an entire area of the first outer peripheral surface.

### Brief Description of Drawings

FIG. 1 is a sectional view of a piezoelectric sensor wire according to one embodiment.
FIG. 2A is an explanatory sectional view for illustrating a first step of a method of manufacturing the piezoelectric sensor wire.
FIG. 2B is an explanatory sectional view for illustrating a second step of the method of manufacturing the piezoelectric sensor wire.
FIG. 2C is an explanatory sectional view for illustrating a third step of the method of manufacturing the piezoelectric sensor wire.
FIG. 3A is an explanatory perspective view for illustrating the third step of the method of manufacturing the piezoelectric sensor wire.
FIG. 3B is an explanatory perspective view for illustrating a fourth step of the method of manufacturing the piezoelectric sensor wire.

### Description of Embodiments

A piezoelectric sensor wire with high accuracy of detection (detection accuracy) and high speed of response (response speed) is required.

The present disclosure provides a piezoelectric sensor wire with high detection accuracy and high response speed.

The piezoelectric sensor wire according to the present disclosure has high detection accuracy and high response speed.
(1) The piezoelectric sensor wire according to the present disclosure includes a core wire, an organic piezoelectric layer, and an electrode region. The core wire includes: a steel wire; and a covering layer made of copper or a copper alloy covering the steel wire. The core wire has a wire diameter of 30 µm or more and 200 µm or less. The organic piezoelectric layer covers an outer peripheral surface of the core wire so as to be in contact with the outer peripheral surface. The organic piezoelectric layer has an average thickness of 2.5 µm or more and 7.5 µm or less. The electrode region is in contact with the organic piezoelectric layer and surrounds the core wire while being spaced apart from the core wire. A wire diameter of the piezoelectric sensor wire is 300 µm or less. The covering layer is in contact with a first outer peripheral surface being an outer peripheral surface of the steel wire over an entire area of the first outer peripheral surface.

In the piezoelectric sensor wire described in Patent Literature 1, the resin wire corresponds to the steel wire of the present disclosure. The metal foil through which a current mainly flows in the core wire corresponds to the covering layer of the present disclosure. In the piezoelectric sensor wire described in Patent Literature 1, the metal foil is wound around the resin wire. Thus, the metal foil may be prevented from being in contact with an outer peripheral surface of the resin wire, and a gap may be defined between the metal foil and the outer peripheral surface. In this case, accuracy of detection of the piezoelectric sensor wire decreases due to the gap. Meanwhile, in the core wire of the piezoelectric sensor wire according to the present disclosure, the covering layer through which a current mainly flows in the core wire is in contact with the first outer peripheral surface of the steel wire over its entire area. Thus, the above-mentioned gap is not formed. Accordingly, the piezoelectric sensor wire has high accuracy of detection.

In the piezoelectric sensor wire of Patent Literature 1, a thickness of the organic piezoelectric layer is as large as 40 µm. Thus, the piezoelectric sensor wire has low response speed. Meanwhile, in the piezoelectric sensor wire according to the present disclosure, the average thickness of the organic piezoelectric layer is as small as 2.5 µm or more and 7.5 µm or less. Thus, the piezoelectric sensor wire has high response speed.

As a result, the piezoelectric sensor wire according to the present disclosure has high detection accuracy and high response speed.
(2) In the above-mentioned item (1), the piezoelectric sensor wire may further include an insulating layer that covers the electrode region. This configuration enables insulation of the electrode region from the outside. Thus, the detection accuracy of the piezoelectric sensor wire can be increased.
(3) In the above-mentioned item (2), a minimum thickness of the insulating layer may be 18 µm or more and 22 µm or less. This configuration enables achievement of both high detection accuracy and downsizing of the piezoelectric sensor wire.
(4) In any one of the above-mentioned items (1) to (3), the electrode region may include a plurality of electrode wires arranged side by side in a circumferential direction. This configuration stabilizes the detection accuracy of the piezoelectric sensor wire.
(5) In the above-mentioned item (4), the electrode wires may be helically wound around the organic piezoelectric layer. This configuration reduces a contact area between the electrode wires and the organic piezoelectric layer, and increases a pressure on the organic piezoelectric layer relative to an apparent pressure, as compared to a configuration in which the electrode wires are arranged on the organic piezoelectric layer in parallel to an axis of the core wire (that is, a configuration in which axes of the electrode wires and the axis of the core wire are parallel). Thus, the above-mentioned configuration improves the amount of power generation. Further, the above-mentioned configuration allows reliable contact of a conductor with the organic piezoelectric layer having low wettability, and thus is suitable for manufacture of a long piezoelectric sensor wire.
(6) In any one of the above-mentioned items (1) to (5), the covering layer may be a plating layer. This configuration allows reliable contact of an inner peripheral surface of the covering layer with the first outer peripheral surface over its entire area. Thus, the detection accuracy of the piezoelectric sensor wire can be increased.
(7) In any one of the above-mentioned items (1) to (6), for an orthogonal cross section being a cross section orthogonal to a longitudinal direction of the core wire, an area ratio of the covering layer in the core wire may be 30% or more and 60% or less. This configuration can enhance electrical conductivity and mechanical strength of the core wire. Thus, the piezoelectric sensor wire has high detection accuracy and high mechanical strength.
(8) In any one of the above-mentioned items (1) to (7), the steel wire may be made of stainless steel. This configuration can improve corrosion resistance of the steel wire.
(9) In the above-mentioned item (8), the stainless steel may be austenitic stainless steel. Austenitic stainless steel is suitable for the steel wire of the piezoelectric sensor wire.
(10) In any one of the above-mentioned items (1) to (9), the steel wire may be made of carbon steel. This configuration can improve mechanical strength of the steel wire.

### [Details of One Embodiment of Present Disclosure]

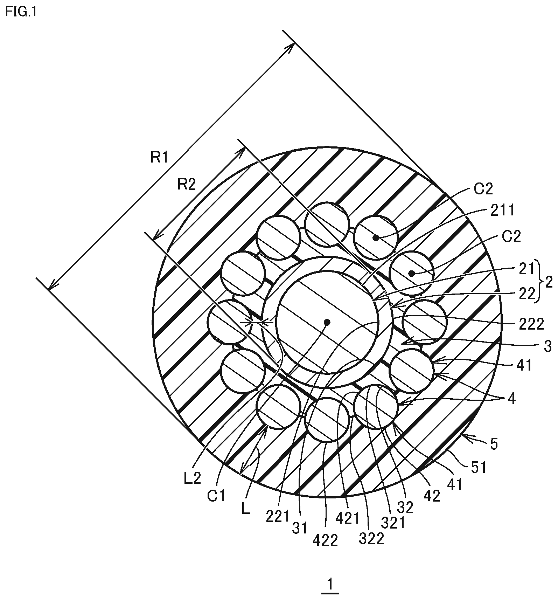

A piezoelectric sensor wire according to one embodiment of the present disclosure is described with reference to FIG. 1. FIG. 1 is a sectional view of a piezoelectric sensor wire according to one embodiment. In the drawings referred to below, the same or corresponding portions are denoted by the same reference symbols, and description thereof is not repeated.

As illustrated in FIG. 1, a piezoelectric sensor wire 1 has a circular shape in an orthogonal cross section being a cross section orthogonal to a longitudinal direction. A wire diameter R1 of the piezoelectric sensor wire 1 is 50 µm or more, and may be 100 µm or more. The wire diameter R1 of the piezoelectric sensor wire 1 is 300 µm or less, and may be 250 µm or less, 200 µm or less, or 150 µm or less. The piezoelectric sensor wire 1 includes a core wire 2, an organic piezoelectric layer 3, an electrode region 4, and an insulating layer 5.

### [Core Wire 2]

The core wire 2 has a circular shape in an orthogonal cross section. The core wire 2 has an axis C1. The core wire 2 includes a steel wire 21 and a covering layer 22. The steel wire 21 has a circular shape in an orthogonal cross section. The steel wire 21 has a first outer peripheral surface 211 being an outer peripheral surface (circumferential surface). The steel wire 21 is made of stainless steel or carbon steel. Examples of the stainless steel include austenitic stainless steel and ferritic stainless steel. Austenitic stainless steel is suitable for the steel wire 21 of the piezoelectric sensor wire 1.

The covering layer 22 covers the steel wire 21. The covering layer 22 has an annular shape in an orthogonal cross section. The covering layer 22 is in contact with the first outer peripheral surface 211 over its entire area. In other words, the covering layer 22 is in close contact with the first outer peripheral surface 211. The covering layer 22 has an inner peripheral surface 221 and a second outer peripheral surface 222. The inner peripheral surface 221 is in contact with the first outer peripheral surface 211 of the steel wire 21 over its entire area. The second outer peripheral surface 222 is an outer peripheral surface positioned away from the first outer peripheral surface 211 of the steel wire 21. The covering layer 22 is made of copper or a copper alloy. Examples of the copper alloy include a copper-silver alloy. The covering layer 22 may contain incidental impurities. The covering layer 22 is a plating layer. For the orthogonal cross section, an area ratio of the covering layer 22 in the core wire 2 is 30% or more, and may be 40% or more. For the orthogonal cross section, the area ratio of the covering layer 22 in the core wire 2 is 60% or less, and may be 55% or less. The area ratio of the covering layer 22 in the core wire 2 is approximate to an electrical conductivity of the core wire 2. That is, the area ratio of the covering layer 22 in the core wire 2 can be defined in percent international annealed copper standard (%IACS). A wire diameter R2 of the core wire 2 is 30 µm or more, and may be 40 µm or more, or 50 µm or more. The wire diameter R2 of the core wire 2 is 200 µm or less, and may be 150 µm or less, 100 µm or less, or 70 µm or less.

### [Organic Piezoelectric Layer 3]

The organic piezoelectric layer 3 covers the outer peripheral surface of the core wire 2 so as to be in contact with the outer peripheral surface of the core wire 2. In other words, the organic piezoelectric layer 3 covers the second outer peripheral surface 222 so as to be in contact with the second outer peripheral surface 222 of the covering layer 22. The organic piezoelectric layer 3 has a second inner peripheral surface 31 and a third outer peripheral surface 32. The second inner peripheral surface 31 is an inner peripheral surface being in contact with the second outer peripheral surface 222 of the covering layer 22 over its entire area. The third outer peripheral surface 32 is an outer peripheral surface positioned away from the second outer peripheral surface 222. The third outer peripheral surface 32 has a shape that conforms to an outer shape of the electrode region 4. The third outer peripheral surface 32 has a plurality of recessed portions 321 and a plurality of connecting portions 322. The recessed portions 321 and the connecting portions 322 are alternately arranged side by side in a circumferential direction. The circumferential direction is a direction along a circumference of the core wire 2 about the axis C1. The plurality of recessed portions 321 are arranged so as to be spaced apart from each other in the circumferential direction. Each of the plurality of recessed portions 321 is recessed toward the core wire 2. The connecting portions 322 each connect the recessed portions 321 being adjacent to each other. Each of the connecting portions 322 has an arc-like shape with respect to the axis C1 in an orthogonal cross section.

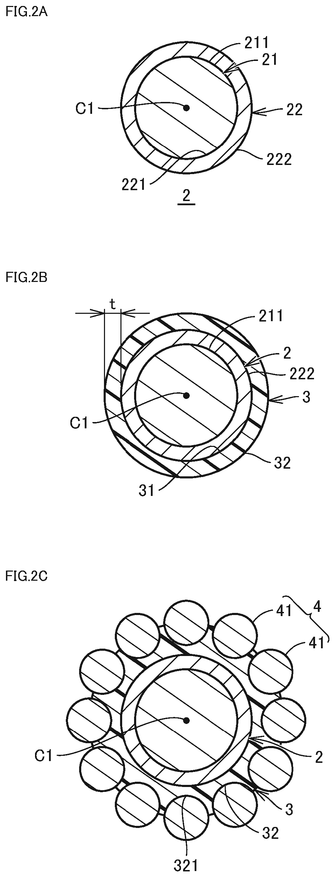

An average thickness "t" (see FIG. 2B) of the organic piezoelectric layer 3 is 2.5 µm or more, and may be 3 µm or more, or 4 µm or more. The average thickness "t" (see FIG. 2B) of the organic piezoelectric layer 3 is 7.5 µm or less, and may be 7 µm or less, or 6 µm or less. Further, a ratio (t/R1) of the average thickness "t" of the organic piezoelectric layer 3 to the wire diameter R1 of the piezoelectric sensor wire 1 is 0.001 or more, and may be 0.005 or more, or 0.008 or more. The ratio (t/R1) of the average thickness "t" of the organic piezoelectric layer 3 to the wire diameter R1 of the piezoelectric sensor wire 1 is 0.15 or less, and may be 0.1 or less, or 0.08 or less. The organic piezoelectric layer 3 is relatively soft and has flexibility. The average thickness "t" of the organic piezoelectric layer 3 is an average of different thicknesses at a plurality of points on the organic piezoelectric layer 3 in the circumferential direction. The average thickness "t" of the organic piezoelectric layer 3 can also be calculated by stripping the electrode region 4 (electrode wires 41) described later away and obtaining an average value of three points equally spaced apart from each other in the circumferential direction on the organic piezoelectric layer 3 (calculating method A). The average thickness "t" of the organic piezoelectric layer 3 is calculated from the above-mentioned wire diameter R2 of the core wire 2 and a sectional area of the organic piezoelectric layer 3 (calculating method B). Examples of a material for the organic piezoelectric layer 3 include polyvinylidene fluoride, a copolymer of vinylidene fluoride and trifluoroethylene, a copolymer of vinylidene fluoride and tetrafluoroethylene, and a silicone resin.

### [Electrode Region 4]

The electrode region 4 is in contact with the organic piezoelectric layer 3 and surrounds the core wire 2 while being spaced apart from the core wire 2. The electrode region 4 includes a plurality of electrode wires 41. Specifically, the electrode region 4 is formed of the plurality of electrode wires 41. The plurality of electrode wires 41 are arranged side by side in the circumferential direction. In the present disclosure, two electrode wires 41 being adjacent to each other in the circumferential direction are positioned away from each other. Although not shown, two electrode wires 41 being adjacent to each other in the circumferential direction may be in contact with each other. Part of each of the plurality of electrode wires 41 is embedded in the organic piezoelectric layer 3. The electrode wires 41 are helically wound around the organic piezoelectric layer 3. The electrode wires 41 each have a circular shape in a cross section orthogonal to a longitudinal direction of the electrode wire 41. Further, the plurality of electrode wires 41 each have an axis C2. The axes C2 are positioned away from the axis C1 of the core wire 2. The electrode wires 41 each have a fourth outer peripheral surface 42. The fourth outer peripheral surface 42 is an outer peripheral surface (circumferential surface) of the electrode wire 41. A first part 421 being part of the fourth outer peripheral surface 42 is in contact with part of the third outer peripheral surface 32. Although not shown, the electrode region 4 may be an electrode sheet (electrode foil). A length (width) of the electrode sheet in the circumferential direction is longer than a length (thickness) of the electrode sheet in a radial direction. The electrode sheet may be a single electrode sheet.

### [Insulating Layer 5]

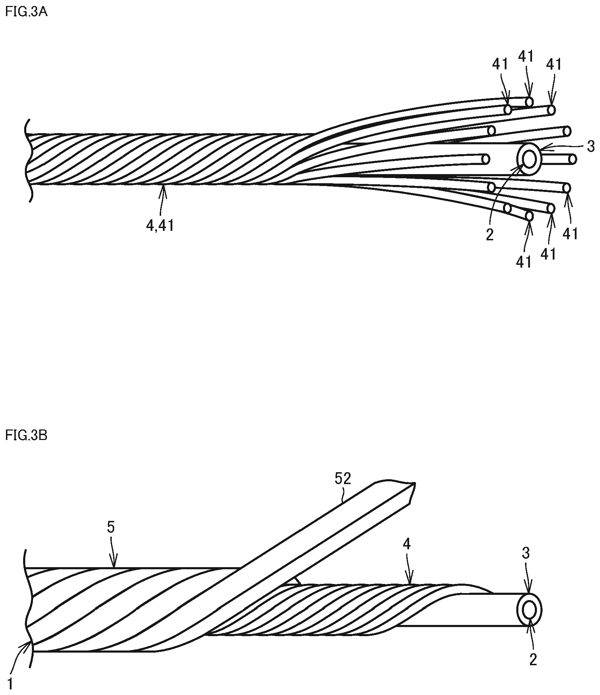

As illustrated in FIG. 1, the insulating layer 5 covers the electrode region 4. Specifically, the insulating layer 5 is in contact with second parts 422. The second part 422 is part of the fourth outer peripheral surface 42 of the electrode wire 41, the part being not in contact with the third outer peripheral surface 32. The insulating layer 5 may be further in contact with the connecting portions 322. The insulating layer 5 has an outer peripheral surface (circumferential surface) 51. The outer peripheral surface 51 corresponds to an outer peripheral surface of the piezoelectric sensor wire 1. A minimum thickness L of the insulating layer 5 is 10 µm or more, and may be 18 µm or more. The minimum thickness L of the insulating layer 5 is 25 µm or less, and may be 22 µm or less. The minimum thickness L is a distance between a point on the second part 422 closest to the outer peripheral surface 51 and the outer peripheral surface 51. Examples of a material for the insulating layer 5 include a resin. Examples of the resin include a polyester resin, a polyolefin resin, a fluororesin, a silicone resin, an ethylene-vinyl acetate copolymer, and a rubber. The insulating layer 5 may be a tape 52 (see FIG. 3B) that is helically wound around the organic piezoelectric layer 3 and the electrode region 4. The tape 52 is formed of the above-mentioned resin.

### [Method of Manufacturing Piezoelectric Sensor Wire 1]

With reference to FIG. 2A to FIG. 3B, a method of manufacturing the piezoelectric sensor wire 1 is described. FIG. 2A to FIG. 2C are explanatory sectional views for illustrating the method of manufacturing the piezoelectric sensor wire 1. FIG. 2A shows a first step of the method of manufacturing the piezoelectric sensor wire. FIG. 2B is an explanatory sectional view for illustrating a second step of the method of manufacturing the piezoelectric sensor wire. FIG. 2C is an explanatory sectional view for illustrating a third step of the method of manufacturing the piezoelectric sensor wire. FIG. 3A and FIG. 3B are explanatory perspective views for illustrating the method of manufacturing the piezoelectric sensor wire 1. FIG. 3A is an explanatory perspective view for illustrating the third step of the method of manufacturing the piezoelectric sensor wire. FIG. 3A corresponds to FIG. 2C. FIG. 3B is an explanatory perspective view for illustrating the third step of the method of manufacturing the piezoelectric sensor wire. FIG. 3B corresponds to FIG. 1.

The method of manufacturing the piezoelectric sensor wire 1 includes the first step, the second step, the third step, and the fourth step. The first step, the second step, the third step, and the fourth step are carried out in the stated order in the method of manufacturing the piezoelectric sensor wire 1.

### [First Step]

As illustrated in FIG. 2A, in the first step, the core wire 2 is prepared. In the first step, the covering layer 22 is formed on the first outer peripheral surface 211 of the steel wire 21. The covering layer 22 is formed by plating. The covering layer 22 is in contact with the first outer peripheral surface 211 of the steel wire 21 over its entire area.

### [Second Step]

As illustrated in FIG. 2B, in the second step, the organic piezoelectric layer 3 is formed on the outer peripheral surface (second outer peripheral surface 222) of the core wire 2. The organic piezoelectric layer 3 is formed by, for example, applying and drying a coating composition containing the above-mentioned material. The organic piezoelectric layer 3 may be formed by extruding (extrusion molding) the above-mentioned material. The third outer peripheral surface 32 has a circular shape in an orthogonal cross section. The third outer peripheral surface 32 and the first outer peripheral surface 211 share the axis C1 (see FIG. 1).

### [Third Step]

As illustrated in FIG. 2C and FIG. 3A, the electrode region 4 is formed so as to be in contact with the organic piezoelectric layer 3. Specifically, the plurality of electrode wires 41 are helically wound around the organic piezoelectric layer 3. At this time, the electrode wires 41 are moved closer to the core wire 2 (see FIG. 2C) from an outer side of the organic piezoelectric layer 3. Meanwhile, the electrode wires 41 are spaced apart from the core wire 2. That is, the electrode wires 41 are not in contact with the core wire 2. The third outer peripheral surface 32 of the organic piezoelectric layer 3 conforms to outer shapes of the plurality of electrode wires 41 along with the above-mentioned movement of the electrode wires 41. That is, the third outer peripheral surface 32 of the organic piezoelectric layer 3 is deformed through the third step. The recessed portions 321 are formed in the third outer peripheral surface 32. Further, part of each of the plurality of electrode wires 41 is embedded in the organic piezoelectric layer 3. Thus, as illustrated in FIG. 2B and FIG. 2C, the average thickness "t" of the organic piezoelectric layer 3 corresponds to a thickness "t" of the organic piezoelectric layer 3 under a state in which the electrode wires 41 are not embedded therein, that is, before the electrode wires 41 are embedded therein.

### [Fourth Step]

As illustrated in FIG. 1 and FIG. 3B, in the fourth step, the insulating layer 5 is arranged so as to cover the electrode region 4. The tape 52 made of a resin is helically wound around the electrode region 4. The tape 52 is wound around the electrode region 4 so that part of the tape 52 (its ends in a width direction) overlaps. Through the fourth step, the piezoelectric sensor wire 1 is manufactured.

### [How to Use Piezoelectric Sensor Wire 1]

The piezoelectric sensor wire 1 is used for a pressure-sensitive sensor or the like. The piezoelectric sensor wire 1 is, for example, mounted to a target object. When the target object is deformed, an external force is applied to the piezoelectric sensor wire 1. Then, the organic piezoelectric layer 3 is deformed. As a result, a potential difference is generated between the core wire 2 and the electrode region 4. A current flowing based on the potential difference is detected by a detection device. The detection device is electrically connected to the core wire 2 or the electrode region 4. The detection device obtains the external force based on the detected current.

### [Modification Example of Piezoelectric Sensor Wire]

The electrode wires 41 may be bundled around the organic piezoelectric layer 3 so as to be in parallel to the axis C1 of the core wire 2.

It is to be understood that the embodiment disclosed herein are merely an example in all aspects and in no way intended to limit the present disclosure. The scope of the present invention is defined by the appended claims and not by the above description, and it is intended that the present invention encompasses all modifications made within the scope and spirit equivalent to those of the appended claims. Further, the embodiment should be understood that at least one of the configurations described in the embodiment may be appropriately combined or may be modified in various ways.

### Reference Signs List

1 piezoelectric sensor wire, 2 core wire, 3 organic piezoelectric layer, 4 electrode region, 5 insulating layer, 21 steel wire, 22 covering layer, 31 second inner peripheral surface (organic piezoelectric layer), 32 third outer peripheral surface (organic piezoelectric layer), 41 electrode wire, 42 fourth outer peripheral surface (electrode wire), 51 outer peripheral surface (insulating layer), 52 tape, 211 first outer peripheral surface (steel wire), 221 inner peripheral surface (covering layer), 222 second outer peripheral surface (covering layer), 321 recessed portion, 322 connecting portion, 421 first part (fourth outer peripheral surface), 422 second part (fourth outer peripheral surface), R1 wire diameter (piezoelectric sensor wire), R2 wire diameter (core wire), "t" average thickness (organic piezoelectric layer)

## Claims

1. A piezoelectric sensor wire, comprising:
a core wire including:
a steel wire; and
a covering layer made of copper or a copper alloy covering the steel wire,
the core wire having a wire diameter of 30 µm or more and 200 µm or less;
an organic piezoelectric layer that covers an outer peripheral surface of the core wire so as to be in contact with the outer peripheral surface and has an average thickness of 2.5 µm or more and 7.5 µm or less; and
an electrode region that is in contact with the organic piezoelectric layer and surrounds the core wire while being spaced apart from the core wire,
wherein a wire diameter of the piezoelectric sensor wire is 300 µm or less, and
wherein the covering layer is in contact with a first outer peripheral surface being an outer peripheral surface of the steel wire over an entire area of the first outer peripheral surface.

2. The piezoelectric sensor wire according to claim 1, further comprising an insulating layer that covers the electrode region.

3. The piezoelectric sensor wire according to claim 2, wherein a minimum thickness of the insulating layer is 18 µm or more and 22 µm or less.

4. The piezoelectric sensor wire according to any one of claims 1 to 3, wherein the electrode region includes a plurality of electrode wires arranged side by side in a circumferential direction.

5. The piezoelectric sensor wire according to claim 4, wherein the electrode wires are helically wound around the organic piezoelectric layer.

6. The piezoelectric sensor wire according to any one of claims 1 to 5, wherein the covering layer is a plating layer.

7. The piezoelectric sensor wire according to any one of claims 1 to 6, wherein, for an orthogonal cross section being a cross section orthogonal to a longitudinal direction of the core wire, an area ratio of the covering layer in the core wire is 30% or more and 60% or less.

8. The piezoelectric sensor wire according to any one of claims 1 to 7, wherein the steel wire is made of stainless steel.

9. The piezoelectric sensor wire according to claim 8, wherein the stainless steel is austenitic stainless steel.

10. The piezoelectric sensor wire according to any one of claims 1 to 9, wherein the steel wire is made of carbon steel.
